Europäisches Patentamt

European Patent Office

Office européen des brevets

(11) Publication number : **0 511 877 A1**

## (12) EUROPEAN PATENT APPLICATION

(21) Application number : 92303959.8

(22) Date of filing : 30.04.92

(51) Int. Cl.⁵ : **H01L 21/76**

(30) Priority : **01.05.91 US 694461**

(43) Date of publication of application :
**04.11.92 Bulletin 92/45**

(84) Designated Contracting States :
**DE FR GB IT**

(71) Applicant : **SGS-THOMSON
MICROELECTRONICS, INC.
1310 Electronics Drive
Carrollton Texas 75006 (US)**

(72) Inventor : **Chan, Tsui Chiu
1633 Camero Drive
Carrollton, Texas 75006 (US)**

(74) Representative : **Palmer, Roger et al
PAGE, WHITE & FARRER 54 Doughty Street
London WC1N 2LS (GB)**

(54) **Manufacture of CMOS devices.**

(57) A method for forming field oxide regions on an integrated circuit device includes the steps of providing, doped regions for formation of active devices. After the doped regions have been formed, a thick field oxide layer is grown over the entire surface of the device. Field oxide regions are then defined using masking and anisotropic etching steps which provide approximately vertical sidewalls for the field oxide regions, and which do not result in the formation of bird's beaks. Since the active regions are defined prior to formation of the field oxide regions, the active regions extend under the field oxide regions and do not give rise to edge effects.

FIG. 8

The present invention relates generally to semiconductor integrated circuits, and more specifically to a method for manufacturing complementary field effect devices (CMOS) in an integrated circuit.

In general, the industry continues to try to make integrated circuit devices smaller. Smaller chips, in general, are less expensive and often provide better performance. However, various problems related to the physical size of components on the integrated circuit become important as devices are scaled to smaller and smaller sizes.

Currently, local oxidation techniques are used to form field oxide regions between devices. Such techniques are often referred to as LOCal Oxidation of Silicon (LOCOS). In general, these techniques provide for covering active areas of the semiconductor chip with a protective oxide/nitride layer. This layer is removed where field oxide regions are to be grown, and a high temperature oxide is grown on the device. Oxide grows in the exposed regions, and not under the nitride layer. This technique causes the formation of the well known "bird's beak", which extends partway into the active areas surrounding the field oxide region.

As device scales continue to shrink, problems are encountered as a result of the bird's beak phenomenon. Various edge effects occur in channel regions located adjacent the bird's beak, which can cause significant performance problems in narrow width transistors. In order to avoid these edge effects, transistors cannot generally be made smaller than certain minimum sizes. These minimum allowable transistor sizes place limits on the spacing of devices within the integrated circuit, thereby limiting the device scaling which can be realized.

It would be desirable to provide a method for forming field oxide regions within an integrated circuit which does not cause edge effects within adjacent field effect devices, thereby allowing additional shrinkage in device feature sizes.

Therefore, in accordance with the present invention, a method for forming field oxide regions on an integrated circuit device includes the steps of providing doped regions for formation of active devices. After the doped regions have been formed, a thick field oxide layer is grown over the entire surface of the device. Field oxide regions are then defined using masking and anisotropic etching steps which provide approximately vertical sidewalls for the field oxide regions, and which do not result in the formation of bird's beaks. Since the active regions are defined prior to formation of the field oxide regions, the active regions extend under the field oxide regions and do not give rise to edge effects.

The novel features believed,characteristic of the invention are set forth in the appended claims. The invention;itself however, as well as a preferred mode of use, and further objects and advantages thereof, will best be understood by reference to the following detailed description of an illustrative embodiment when read in conjunction with the accompanying drawings, wherein:

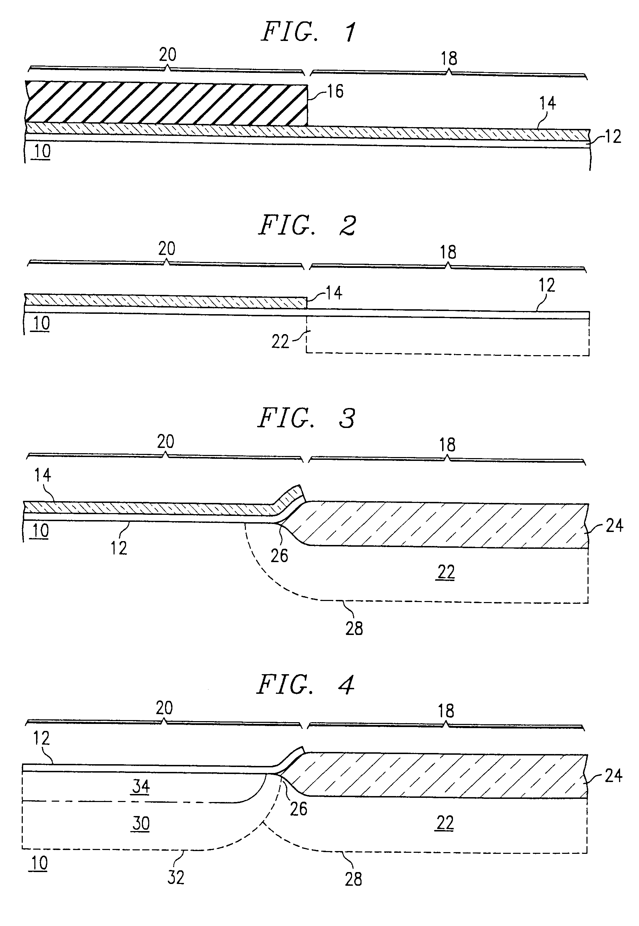

**Figures 1 - 8** illustrate a preferred method for forming semiconductor structures according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1**, integrated circuit devices are to be fabricated in a substrate **10**. Although various substrate types can be used, for the preferred embodiment described herein an N-type substrate having an impurity concentration of approximately $10^{14}$ to $5 \times 10^{15}$ atoms/cm$^3$ is used. The substrate **10** preferably has a <100> crystal orientation.

A pad oxide layer **12** is thermally grown over the substrate **10**, followed by deposition of a silicon nitride layer **14**. A layer of photoresist **16** is then deposited over the device, and patterned to expose regions **18** in which N-wells will be formed. The remaining resist regions **16** remain over regions **20** in which P-wells will be formed.

Referring to **Figure 2**, the nitride layer **14** is removed over the N-well regions, using the photoresist layer **16** as a mask. In the preferred embodiment, phosphorous is implanted at a dosage of $6 \times 10^{12}$ atoms/cm$^2$ at 150 KeV. In conjunction with later processing steps, this dosage provides the desired field threshold voltages $V_{Tfp}$. After the N-well implant, the photoresist layer **16** is removed.

Referring to **Figure 3**, a field oxide region **24** is then thermally grown in the N-well region **18**. The nitride layer **14** acts as a mask to prevent formation of field oxide within the P-well region **20** as is in the art. The field oxide **24** is preferably grown to a thickness of at least approximately 5000 angstroms. As known in the art, the field oxide **24** will grown down into the substrate **10** as well as above it, and a bird's beak **26** will be formed. This oxide growth step causes the N-well junction **28** to move from its initial location, diffusing down into the substrate and laterally into the edge of the P-well region **20**.

Referring to **Figure 4**, the remaining portions of the nitride layer **14** are removed. A blanket P-well implant is then made to define the P-well. Preferably, boron is implanted at a dose of $2.5 \times 10^{12}$ atoms/cm$^2$ at a power of 50 KeV. This is followed by a heating step to drive the P-well junction **32** to a depth of approximately three to four microns.

An N-channel implant is then made into the P-well **30** to form a region **34** suitable for the fabrication of N-channel transistors. Preferably, boron is implanted at a dosage of approximately $3 \times 10^{13}$ atoms/cm$^2$ at an energy of 50 KeV to provide the desired field threshold voltage $V_{Tfn}$. The thick field oxide layer **24** protects the N-well region **18** during both of these boron implantation steps.

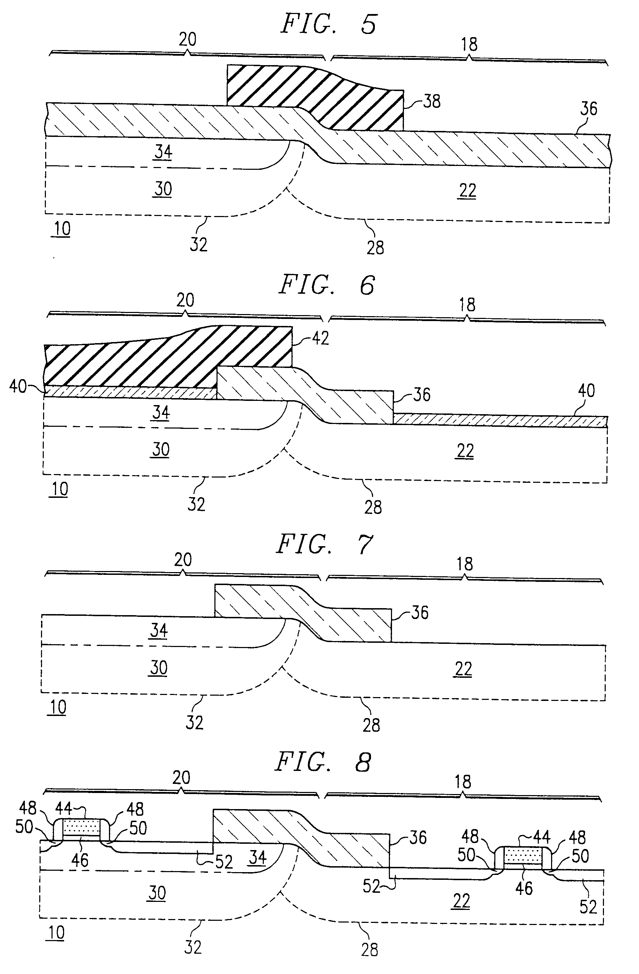

Referring to **Figure 5**, all oxide layers are removed. A layer of field oxide **36** is thermally grown over the entire device, preferably to a thickness of approximately 4000 angstroms. A layer of photoresist **38** is then deposited over the field oxide layer **36**, and patterned as shown to define regions where field oxide is to remain on the finished device.

Referring to **Figure 6**, the field oxide **36** is etched using the patterned resist **38** as a mask, which is then removed. This leaves regions of field oxide **36** in desired locations on the device. As known in the art, field oxide **36** is typically left in all areas in which N-well regions **18** and P-well regions **20** are adjacent. Field oxide **36** is also left to separate devices in the same type of well.

After removal of the photoresist **38**, a layer of oxide **40** is grown to remove damaged silicon at the surface of the active areas. This layer is often referred to as a sacrificial layer. A blanket implant is then made to adjust the $V_{Tn}$ and $V_{Tfp}$ for the device so that $V_{Tn}$ is adjusted to the correct value. A layer of photoresist **42** is then formed over the device and patterned to expose the active areas within the N-well regions **20**. A masked implant is then performed to adjust $V_{Tp}$ to the correct value.

Referring to Figure 7, the resist layer **42** is removed, followed by removal of the oxide layer **40**. This results in the structure shown in **Figure 7**. All P-wells **20** and N-wells **18** have been defined. The field oxide regions **36** have been defined, and the threshold voltages have been adjusted where necessary. The integrated circuit device is now ready for the formation of CMOS devices and interconnect. These following process steps generally begin with the growth of a gate oxide layer (not shown), followed by additional steps as known in the art.

**Figure 8** illustrates the device at a later stage of fabrication. Techniques for forming the devices shown are conventional. Transistor gates **44** are formed over gate oxide **46**. Sidewall oxide spacers **48** allow the formation of lightly doped drain regions **50** adjacent the source/drain regions **52**. Later interlevel oxide layers and interconnect layers are not shown, and are formed as known in the art.

The method described above results in the formation of field oxide regions which do not have the bird's beak structures characteristic of local oxidation processes. The P-well and N-well regions **20, 18** extend under the field oxide **36**, so that no transition occurs at the edges. This minimizes the edge effects which tend to become more pronounced at small feature sizes. This means that transistors can be made smaller than before, resulting in increased device density.

With the thin gate oxides used in the described method, only a very light $V_T$ adjust implant needs to be made for the N-channel devices. The surface dopant concentrations for the channels of the N-channel devices is therefore very close to that for the parasite field devices under the field oxide. Since there is no large change in dopant concentrations at the edges of the field oxide regions, edge effects due to sharp concentration gradients are minimized.

When using the described method, a fairly abrupt step occurs at the edges of the field oxide. One advantage of local oxidation processes is that the bird's beak which is formed provides a less abrupt step at the field oxide edges. With the current technique, various known techniques can be used to improve the step profile if desired. For example, sidewall oxide spacers can be formed alongside the field oxide regions. A reflowable glass can be planarized and etched back to round the bottom portions of the step. Various techniques are available if they are needed.

While the invention has been particularly shown and described with reference to a preferred embodiment, it will be understood by those skilled in the art that various changes in form and detail may be made therein without departing from the spirit and scope of the invention.

## Claims

1. A method for forming semiconductor integrated circuit structures, comprising the steps of:

   forming wells having impurities in a semiconductor substrate;

   forming a layer of oxide over the substrate; and

   patterning the oxide layer to define field oxide regions, wherein portions of the wells extend under the field oxide regions.

2. The method of Claim 1, wherein said forming step comprises the step of growing a layer of thermal oxide over the substrate.

3. The method of Claim 1, wherein some of the wells have a P conductivity type, and other wells have an N conductivity type.

4. The method of Claim 1, wherein said wells forming step comprising the steps of:

   implanting an N-type impurity into the substrate to form N-wells;

   growing an oxide layer over the N-wells;

and

implanting P-wells into the substrate in location not containing N-wells.

5. The method of Claim 4, wherein said step of implanting an N-type impurity comprises the steps of:

forming a thin protective layer over the substrate;

forming a photoresist layer over the substrate where N-wells are not desired; and

implanting the N-type impurity into the substrate, wherein the photoresist layer masks underlying regions from the impurity implant.

6. The method of Claim 5, wherein the thin protective layer comprises an oxide layer on the substrate, covered in turn by a nitride layer.

7. The method of Claim 4, wherein said oxide growing step comprises the steps of:

forming a nitride layer over the regions in which P-wells are to be formed; and

oxidizing the substrate to form a thick oxide in regions not covered by the nitride layer.

8. The method of Claim 4, wherein said P-well implanting step comprises the steps of:

implanting a P-type impurity into regions not covered by the oxide layer;

heating the substrate to drive the P-type impurities to a depth approximately equal to the depth of the N-wells; and

implanting additional P-type impurities into the P-well region.

9. The method of Claim 1, wherein said patterning step comprises the steps of:

patterning a layer of photoresist over the oxide layer; and

etching the oxide layer using the photoresist as an etch mask.

10. The method of Claim 9, wherein said etching step comprises an anisotropic etch

11. The method of Claim 9, wherein the patterned photoresist covers regions where P-wells and N-well are immediately adjacent.

12. The method of Claim 1, further comprising the steps of:

forming complementary field effect devices in the wells, some of the wells being P-wells and others being N-wells.

13. A structure for integrated circuit devices, comprising:

a semiconductor substrate having an upper surface;

a well having a first conductivity type in said substrate at the upper surface; and

an oxide region on the surface of said substrate, wherein a portion of said well extends under said oxide region.

14. The structure of Claim 13, further comprising:

a field effect transistor formed in said well and on the substrate surface over said well.

15. The structure of Claim 13, further comprising:

a second well in said substrate, said second well being located adjacent to said first well.

16. The structure of Claim 15, wherein said second well has a conductivity type opposite to that of said first well.

17. The structure of Claim 16, wherein said first well has a P conductivity type, and said second well has an N conductivity type.

18. The structure of Claim 16, wherein said first well has an N conductivity type, and said second well has a P conductivity type.

19. The structure of Claim 15, wherein a portion of said second well extends under said oxide region.

20. The structure of Claim 19, wherein said first and second wells meet under said oxide region.

## FIG. 1

## FIG. 2

## FIG. 3

## FIG. 4

*FIG. 5*

*FIG. 6*

*FIG. 7*

*FIG. 8*

6

**European Patent Office**

**EUROPEAN SEARCH REPORT**

Application Number

EP 92 30 3959

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 178 440 (INTERNATIONAL BUSINESS MACHINES) * column 4, line 20 - column 6, line 14; figures 1-14 * | 1-20 | H01L21/76 |
| X | EP-A-0 197 198 (SIEMENS AKTIENGESELLSCHAFT BERLIN UND MÜNCHEN) * column 3, line 34 - column 4, line 28; figures 1-5 * | 1-6,9-20 | |
| X | FR-A-2 533 749 (HITACHI) * page 6, line 2 - page 8, line 30; figures 1A-1F,1N * | 1-8, 12-20 | |

TECHNICAL FIELDS SEARCHED (Int. Cl.5)

H01L

The present search report has been drawn up for all claims

| Place of search | Date of completion of the search | Examiner |
|---|---|---|
| BERLIN | 16 JULY 1992 | LE MINH I. |

EPO FORM 1503 03.82 (P0401)